(19) Europäisches Patentamt
European Patent Office
Office européen des brevets

(11) **EP 3 700 078 A1**

(12) **EUROPEAN PATENT APPLICATION**

(43) Date of publication:
**26.08.2020 Bulletin 2020/35**

(51) Int Cl.:
*H02N 2/10* (2006.01)          *G06F 30/20* (2020.01)
*G06F 3/01* (2006.01)

(21) Application number: **19206168.7**

(22) Date of filing: **30.10.2019**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **20.02.2019 CN 201910127567**

(71) Applicant: **Beijing Xiaomi Mobile Software Co., Ltd.**
**Beijing 100085 (CN)**

(72) Inventor: **CHEN, Chaoxi**
**Beijing, Beijing 100085 (CN)**

(74) Representative: **dompatent von Kreisler Selting Werner -**
**Partnerschaft von Patent- und Rechtsanwälten mbB**
**Deichmannhaus am Dom**
**Bahnhofsvorplatz 1**
**50667 Köln (DE)**

(54) **METHOD AND DEVICE FOR SELECTING VIBRATION MOTOR, TERMINAL AND STORAGE MEDIUM**

(57) The present disclosure relates to a method and device for selecting a vibration motor, a terminal, and a storage medium. The method comprises: acquiring vibration frequencies of n candidate vibration motors for the terminal, n being an integer greater than 1; calculating the vibration quantity of the terminal driven by each candidate vibration motor respectively according to the vibration frequencies of the n candidate vibration motors; and selecting a target vibration motor suitable for the terminal from the n candidate vibration motors according to the vibration quantities corresponding to the n candidate vibration motors, respectively.

Vibration frequencies of n candidate vibration motors for the terminal are acquired, n being an integer greater than 1.  — 101

A vibration quantity of the terminal driven by each candidate vibration motor is calculated according to the vibration frequencies of the n candidate vibration motors.  — 102

A target vibration motor suitable for the terminal is selected from the n candidate vibration motors according to the vibration quantities corresponding to the n candidate vibration motors, respectively.  — 103

**FIG. 1**

**Description**

TECHNICAL FIELD

The present disclosure relates to the field of terminal technologies, and in particular, to a method and device for selecting a vibration motor, a terminal, and a storage medium.

BACKGROUND

Vibration touch, as an important means for achieving non-visual interaction on a terminal such as a mobile phone, is mainly applied to such aspects as information reminder and tactile or haptic feedback of the terminal.
The terminal is usually equipped with a vibration motor, and is driven to vibrate through a driving force generated by the rotation of a motor rotor in the vibration motor, thereby generating a vibration touch. At present, after a terminal state is determined, that is, after the vibration motor is selected, and the selected vibration motor and other components are mounted in the terminal, a relevant tester adopts corresponding test equipment to test and obtain the vibration touch of the terminal. If the test fails, it is required to re-select the vibration motor and re-test.

SUMMARY

Various embodiments of the present disclosure provide a method and device for selecting a vibration motor, a terminal, and a storage medium.
According to a first aspect of the present disclosure, there is provided a method for selecting a target vibration motor among several candidate vibration motors, wherein the target vibration motor is to be arranged in a terminal to drive the terminal to vibrate, and the method includes:

acquiring vibration frequencies of n candidate vibration motors for the terminal, n being an integer greater than 1;
calculating a vibration quantity of the terminal driven by each candidate vibration motor respectively according to the vibration frequencies of the n candidate vibration motors; and
selecting the target vibration motor suitable for the terminal from the n candidate vibration motors according to the vibration quantities corresponding to the n candidate vibration motors, respectively.

In some embodiments, calculating the vibration quantity of the terminal driven by each candidate vibration motor respectively according to the vibration frequencies of the n candidate vibration motors includes:

for an i-th candidate vibration motor in the n candidate vibration motors, calculating a vibration acceleration of the terminal driven by the i-th candidate vibration motor according to the vibration frequency of the i-th candidate vibration motor; and
calculating a vibration quantity $G_i$ of the terminal driven by the i-th candidate vibration motor according to the following formula:

$$G_i = \frac{a_i}{g},$$

wherein $a_i$ represents the vibration acceleration of the terminal driven by the i-th candidate vibration motor, and g represents the gravitational acceleration.
In some embodiments, calculating the vibration acceleration of the terminal driven by the i-th candidate vibration motor according to the vibration frequency of the i-th candidate vibration motor includes:

calculating a driving force generated by the i-th candidate vibration motor according to the vibration frequency of the i-th candidate vibration motor; and
calculating the vibration acceleration $a_i$ of the terminal driven by the i-th candidate vibration motor according to the following formula:

$$a_i = T\frac{F_i}{M},$$

wherein $F_i$ represents the driving force generated by the i-th candidate vibration motor, T represents an amplification coefficient of the vibration quantity, and M represents a mass of the terminal.
In some embodiments, calculating the driving force generated by the i-th candidate vibration motor according to the vibration frequency of the i-th candidate vibration motor includes:

calculating an angular velocity $w_i$ of the i-th candidate vibration motor according to the following formula:

$$w_i = 2\pi f_i,$$

wherein $f_i$ represents the vibration frequency of the i-th candidate vibration motor; and
calculating the driving force $F_i$ generated by the i-th candidate vibration motor according to the following formula:

$$F_i = m_i r_i w_i^2,$$

wherein $m_i$ represents a centroid mass of the i-th candidate vibration motor, and $r_i$ represents a centroid radius of the i-th candidate vibration motor.

In some embodiments, selecting the target vibration motor suitable for the terminal from the n candidate vibration motors according to the vibration quantities corresponding to the n candidate vibration motors includes:

selecting the candidate vibration motor with the largest vibration quantity as the target vibration motor suitable for the terminal from the n candidate vibration motors.

Preferably, the method above may include the step of mounting the target vibration motor to a terminal.

According to a second aspect of the present disclosure, there is provided a device for selecting a target vibration motor among several candidate vibration motors, wherein the target vibration motor is to be arranged in a terminal to drive the terminal to vibrate, the device includes:

an acquisition module, configured to acquire vibration frequencies of n candidate vibration motors for the terminal, n being an integer greater than 1;
a calculation module, configured to calculate a vibration quantity of the terminal driven by each candidate vibration motor according to the vibration frequencies of the n candidate vibration motors; and
a selection module, configured to select the target vibration motor suitable for the terminal from the n candidate vibration motors according to the vibration quantities corresponding to the n candidate vibration motors, respectively.

In some embodiments, the calculation module includes:

an acceleration calculation unit, configured to calculate, for an i-th candidate vibration motor in the n candidate vibration motors, a vibration acceleration of the terminal driven by the i-th candidate vibration motor according to the vibration frequency of the i-th candidate vibration motor; and
a vibration quantity calculation unit, configured to calculate a vibration quantity $G_i$ of the terminal driven by the i-th candidate vibration motor according to the following formula:

$$G_i = \frac{a_i}{g},$$

wherein $a_i$ represents the vibration acceleration of the terminal driven by the i-th candidate vibration motor, and g represents the gravitational acceleration.

In some embodiments, the acceleration calculation unit is configured to:

calculate a driving force generated by the i-th candidate vibration motor according to the vibration frequency of the i-th candidate vibration motor; and calculate the vibration acceleration $a_i$ of the terminal driven by the i-th candidate vibration motor according to the following formula:

$$a_i = T\frac{F_i}{M},$$

wherein $F_i$ represents the driving force generated by the i-th candidate vibration motor, T represents an amplification coefficient of the vibration quantity, and M represents a mass of the terminal.

In some embodiments, the acceleration calculation unit is further configured to:
calculate an angular velocity $w_i$ of the i-th candidate vibration motor according to the following formula:

$$w_i = 2\pi f_i,$$

wherein $f_i$ represents the vibration frequency of the i-th candidate vibration motor; and
calculate the driving force $F_i$ generated by the i-th candidate vibration motor according to the following formula:

$$F_i = m_i r_i w_i^2,$$

wherein $m_i$ represents a centroid mass of the i-th candidate vibration motor, and $r_i$ represents a centroid radius of the i-th candidate vibration motor.

In some embodiments, the selection module is configured to:
select the candidate vibration motor with the largest vibration quantity as the target vibration motor suitable for the terminal from the n candidate vibration motors.

According to a third aspect of the present disclosure, there is provided a device for selecting a target vibration motor, wherein the target vibration motor is to be arranged in a terminal to drive the terminal to vibrate, the device includes:

a processor; and
a memory configured to store instructions executable by the processor,
wherein the processor is configured to:
acquire vibration frequencies of candidate vibration motors for the terminal, n being an integer greater than 1;
calculate a vibration quantity of the terminal driven by each candidate vibration motor respectively according to the vibration frequencies of the n candidate vibration motors; and

select a target vibration motor suitable for the terminal from the n candidate vibration motors according to the vibration quantities corresponding to the n candidate vibration motors, respectively.

According to a fourth aspect of the present disclosure, there is provided a terminal, including: a target vibration motor, wherein the target vibration motor is arranged in the terminal to drive the terminal to vibrate, and is selected by adopting the method in the first aspect.

According to a fifth aspect of the present disclosure, there is provided a non-transitory computer-readable storage medium, wherein a computer program is stored in the storage medium; and the steps of the method in the first aspect are implemented when the computer program is executed by a processor.

The technical solutions of the embodiments of the present disclosure have the following advantageous effects.

The vibration quantity of the terminal driven by each candidate vibration motor is calculated according to the vibration frequencies of the plurality of candidate vibration motors, so that the target vibration motor suitable for the terminal is selected according to the vibration quantity before the target vibration motor is mounted into the terminal. Compared with the related art where the vibration quantity is tested after the vibration motor is mounted in the terminal, the operation in the technical solution provided by the embodiment of the present disclosure is more efficient and more concise as the vibration quantity of the terminal can be calculated without the vibration motor being mounted in the terminal. In addition, calculation and test are performed before the vibration motors are mounted in the terminal in the present disclosure, so that the reasonableness, correctness, and timeliness of selection of the vibration motor are ensured.

It is to be understood that both the foregoing general description and the following detailed description are exemplary and explanatory only and are not intended to limit the present disclosure.

BRIEF DESCRIPTION OF THE DRAWINGS

The accompanying drawings, which are incorporated in and constitute a part of this disclosure, illustrate various embodiments of the present disclosure and, together with the specification, are used to explain the principles of some embodiments of the present disclosure.

FIG. 1 shows a flow diagram of a method for selecting a vibration motor according to an exemplary embodiment of the present disclosure;
FIG. 2 exemplarily shows a schematic diagram of a sinusoidal motion of the motor rotor;

FIG. 3 exemplarily shows a schematic diagram of an eccentric force of the motor rotor;
FIG. 4 is a structural block diagram of a device for selecting a vibration motor according to an exemplary embodiment of the present disclosure;
FIG. 5 is a structural block diagram of a device for selecting a vibration motor according to another exemplary embodiment of the present disclosure;
FIG. 6 is a structural block diagram of a terminal according to an exemplary embodiment of the present disclosure; and
FIG. 7 is a block diagram of a computer equipment according to an exemplary embodiment.

DETAILED DESCRIPTION

Reference will now be made in detail to some embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the present disclosure. Instead, they are merely examples of devices and methods consistent with aspects related to the disclosure as recited in the appended claims.

Vibration touch, as an important means for achieving non-visual interaction on a terminal, is applied to not only information reminder (such as call reminder, alarm clock reminder, and information push reminder), but also tactile or haptic feedback, blind interactions, and other aspects. For example, when an explosion scene is displayed on a terminal, a user can directly feel the real vibration through touch on the terminal besides through traditional ways such as sound and moving pictures. For instance, when closing an automobile door is displayed on the terminal, the user can feel an instant vibration on the terminal. Exemplary, when using a navigation application on the terminal, a user with visual impairment is prompted of such information as the type of road junction ahead, and a turn direction. The above terminal may be electronic equipment such as a mobile phone, a tablet computer, an e-book reader, a game machine, or a wearable equipment.

The terminal is usually equipped with a vibration motor which works on the basis of the electromagnetic induction principle as follows. A coil of the vibration motor is placed in a magnetic field; when a terminal processor detects that vibration is required, a control circuit of the terminal drives current to flow into the coil; thus, the coil is subjected to the Lorentz force, and accordingly, a motor rotor rotates; as the motor rotor is not centrally symmetrical, the rotation of the motor rotor drives the vibration motor to vibrate to generate a driving force; and therefore, the driving force drives the terminal to vibrate so as to generate a vibration touch.

Typically, after the vibration motor is selected, and the selected vibration motor and other components are mounted in the terminal, a relevant tester adopts corresponding test equipment to test the terminal to obtain the vibration touch of the terminal. If the test fails, it is required to re-select the vibration motor and re-test. On the one hand, the operation of the test process for selecting the appropriate vibration motor is cumbersome and inefficient. On the other hand, it is difficult to ensure the reasonableness, correctness, and timeliness of selection of the vibration motor.

In the embodiments of the present disclosure, the vibration quantity of the terminal driven by each candidate vibration motor is calculated according to the vibration frequencies of the plurality of candidate vibration motors, so that the target vibration motor suitable for the terminal is selected according to the vibration quantities before the target vibration motor is mounted into the terminal. Compared with the related art that the vibration quantity is tested after the vibration motor is mounted in the terminal, the operation in the technical solution provided by the embodiments of the present disclosure is more efficient and more concise as the vibration quantity of the terminal can be calculated without the vibration motor being mounted in the terminal. In addition, calculation and test are performed before the vibration motors are mounted in the terminal in the present disclosure, so that the reasonableness, correctness, and timeliness of selection of the vibration motor are ensured.

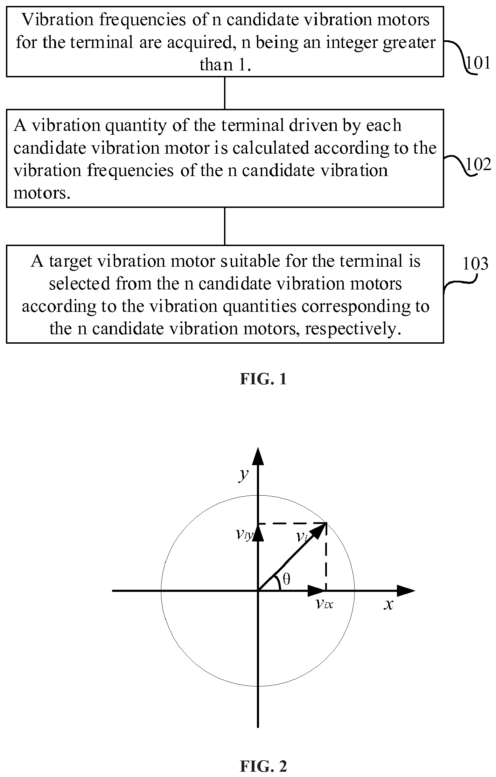

FIG. 1 shows a flow diagram of a method for selecting a vibration motor according to an exemplary embodiment of the present disclosure. The target vibration motor shall be arranged in the terminal to drive the terminal to vibrate. An executive subject in each step of the method provided by the embodiment of the present disclosure may be a computer equipment. The computer equipment is usually a computer, and may be a desktop computer or a laptop portable computer. The method can include the following steps (101-103).

In step 101, vibration frequencies of n candidate vibration motors for the terminal are acquired, n being an integer greater than 1.

The vibration frequency of the vibration motor refers to the frequency of a power source connected to a coil winding of the vibration motor when the vibration motor is in a rated operating state. The frequency is the times of the periodic changes completed within unit time, is a physical quantity describing how often the periodic motion occurs, and is usually expressed by symbol f with the unit of hertz (Hz). Candidate vibration motors are those vibration motors which could possibly serve in a terminal as vibration motor, while the target vibration motor in fact is suitable to be mounted to the terminal in order to generate sufficient and desirable vibration.

In step 102, a vibration quantity of the terminal driven by each candidate vibration motor is calculated according to the vibration frequencies of the n candidate vibration motors.

The above vibration quantity is configured to characterize the vibration touch of the terminal. After acquiring the vibration frequency of the candidate vibration motor, the computer equipment can calculate the vibration quantity of each candidate vibration motor according to a corresponding mathematical model. Thus, the vibration quantity is a measure to indicate vibration. This provides the advantage to make the individual vibration of each candidate vibration motor accessible for comparison. In particular, the vibration quantity is unit-less for ease of comparison.

In some embodiments, calculating the vibration quantity of the terminal driven by each candidate vibration motor according to the vibration frequencies of the n candidate vibration motors includes: for an i-th candidate vibration motor in the n candidate vibration motors, calculating a vibration acceleration of the terminal driven by the i-th candidate vibration motor according to the vibration frequency of the i-th candidate vibration motor; and calculating a vibration quantity $G_i$ of the terminal driven by the i-th candidate vibration motor according to the following formula:

$$G_i = \frac{a_i}{g},$$

wherein $a_i$ represents the vibration acceleration of the terminal driven by the i-th candidate vibration motor, and g represents the gravitational acceleration. Generally, g is 9.8, and its unit is m/s$^2$.

In some embodiments, calculating the vibration acceleration of the terminal driven by the i-th candidate vibration motor according to the vibration frequency of the i-th candidate vibration motor includes: calculating a driving force generated by the i-th candidate vibration motor according to the vibration frequency of the i-th candidate vibration motor; and calculating the vibration acceleration $a_i$ of the terminal driven by the i-th candidate vibration motor according to the following formula:

$$a_i = T\frac{F_i}{M},$$

wherein $F_i$ represents the driving force generated by the i-th candidate vibration motor, T represents an amplification coefficient of the vibration quantity, and M represents the mass of the terminal. The terminal is driven by the driving force generated by the candidate vibration motor to vibrate so as to generate a vibration touch.

When a user wants to produce a terminal (such as a mobile phone) and needs to equip the terminal with a suitable vibration motor, an estimated mass of the terminal is preset by a designer.

In some embodiments, calculating the driving force generated by the i-th candidate vibration motor according to the vibration frequency of the i-th candidate vibration motor includes: calculating an angular velocity $w_i$ of the i-th candidate vibration motor according to the following formula:

$$w_i = 2\pi f_i,$$

wherein $f_i$ represents the vibration frequency of the i-th candidate vibration motor; and

calculating the driving force $F_i$ generated by the i-th candidate vibration motor according to the following formula:

$$F_i = m_i r_i w_i^2,$$

wherein $m_i$ represents a centroid mass of the i-th candidate vibration motor, and $r_i$ represents a centroid radius of the i-th candidate vibration motor. The above centroid mass of the i-th candidate vibration motor refers to the total mass of the i-th candidate vibration motor; and the centroid radius of the i-th candidate vibration motor refers to the centroid radius obtained by equivalently calculating the mass of the candidate vibration motor. The above centroid refers to the center of mass for an object, such as the candidate vibration motor.

In step 103, a target vibration motor suitable for the terminal is selected from the n candidate vibration motors according to the vibration quantities corresponding to the n candidate vibration motors, respectively.

After obtaining the vibration quantity corresponding to each of the n candidate vibration motors, the target vibration motor suitable for the terminal and matched with the mass of the terminal is selected according to the vibration quantity and the mass of the terminal. After the target vibration motor is arranged in the terminal, the terminal can be brought with an excellent vibration touch.

Selecting the target vibration motor suitable for the terminal from the n candidate vibration motors according to the vibration quantities corresponding to the n candidate vibration motors respectively includes: selecting the candidate vibration motor having the largest vibration quantity as the target vibration motor suitable for the terminal from the n candidate vibration motors. Exemplarily, if there are three candidate vibration motors, namely, the candidate vibration motor A, the candidate vibration motor B and the candidate vibration motor C, and their vibration quantities are 10, 15, and 20, respectively, the candidate vibration motor C having the vibration quantity of 20 is selected as the target vibration motor suitable for the terminal.

The candidate vibration motor with the largest vibration quantity can bring a more obvious vibration touch to the terminal, so that the user experience can be improved.

Before the vibration motors are mounted in the terminal, the vibration quantities of the candidate vibration motors are calculated, and the target vibration motor suitable for the terminal is selected according to the calculation results. Thus, a terminal designer can select the vibration motor suitable for the terminal before production of the terminal, and there is no need to test a vibration quantity after the vibration motor is mounted in the terminal. Therefore, the reasonableness, correctness, and timeliness of selection of the vibration motor are ensured.

Therefore, according to some embodiments of the present disclosure, the vibration quantity of the terminal driven by each candidate vibration motor is calculated according to the vibration frequencies of the plurality of candidate vibration motors, so that the target vibration motor suitable for the terminal is selected according to the vibration quantities. Compared with the related art that the vibration quantity is tested after the vibration motor is mounted in the terminal, the operation in the technical solution provided by the embodiment of the present disclosure is more efficient and more concise as the vibration quantity of the terminal can be calculated without the vibration motor being mounted in the terminal. In addition, calculation and test are performed before the vibration motors are mounted in the terminal in the present disclosure, so that the reasonableness, correctness and timeliness in selection of the appropriate vibration motor can be ensured.

Moreover, according to some embodiments of the present disclosure, the vibration motor suitable for the terminal can be selected by theoretical calculation, so that the cost of the process of selection of the vibration motor is lower than that of the related art.

The solution of the driving force $F_i$ generated by the i-th candidate vibration motor will be described in detail.

FIG. 2 exemplarily shows a schematic diagram of a sinusoidal motion of a vibration rotor.

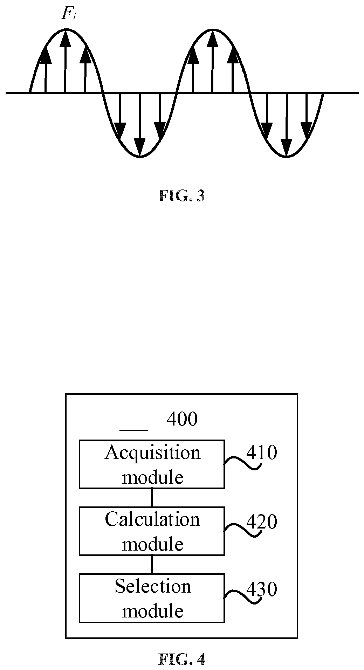

FIG. 3 exemplarily shows a schematic diagram of a driving force generated by the vibration motor.

If a moving velocity of the i-th candidate vibration motor is $v_i$, an included angle between the moving velocity $v_i$ and the x-axis is $\theta$, $\overline{i}$ is an x-axis unit vector, and $\overline{j}$ is a y-axis unit vector, then, the velocity vector can be expressed as:

$$\overline{v_i} = v_i \sin\theta \, \overline{i} + v_i \cos\theta \, \overline{j},$$

wherein $\theta = w_i t$, $w_i$ represents the angular velocity of the i-th candidate vibration motor, and t represents time, then:

$$\overline{v_i} = v_i \sin(w_i t)\overline{i} + v_i \cos(w_i t)\overline{j}.$$

Further, the acceleration $a_{mi}$ of the i-th candidate vibration motor can be expressed as:

$$a_{mi} = \bar{v_i}' = w_i v_i \left[ \cos(w_i t)\bar{i} - \sin(w_i t)\bar{j} \right].$$

Further, $|a_{mi}| = w_i v_i = r_i w_i^2$.

Further, the driving force $F_i$ generated by the i-th candidate vibration can be expressed as: $F_i = m_i|a_{mi}| = m_i r_i w_i^2$.

According to $w = 2\pi f$, the driving force $F_i$ generated by the i-th candidate vibration motor can be expressed as:

$$F_i = m_i r_i (2\pi f_i)^2.$$

In summary, the embodiment of the present disclosure provides not only a derivation process of the acceleration of the vibration motor, but also an evaluation calculation method of the driving force generated by the vibration motor, thereby providing a theoretical basis for evaluating the vibration touch of the terminal.

The following relates to embodiments of a device provided by the present disclosure, and the device may be configured to implement the method provided by the embodiments of the present disclosure. Details not disclosed in the embodiments of the device provided by the present disclosure may refer to the embodiments of the method provided by the present disclosure.

FIG. 4 shows a structure diagram of a device for selecting a vibration motor according to an exemplary embodiment of the present disclosure. The device has a function capable of implementing the above exemplary method for selecting the vibration motor, and the vibration motor is arranged in a terminal to drive the terminal to vibrate. The function may be implemented by hardware or by software executed by the corresponding hardware. The device may be a computer equipment as described above, or may be arranged in the computer equipment. The device 400 includes an acquisition module 410, a calculation module 420, and a selection module 430.

The various device components, units, blocks, or portions may have modular configurations, or are composed of discrete components, but nonetheless can be referred to as "modules" in general. In other words, the "components," "modules," "blocks," "portions," or "units" referred to herein may or may not be in modular forms.

The acquisition module 410 is configured to acquire vibration frequencies of n candidate vibration motors for the terminal, n being an integer greater than 1. The acquisition module 410 may comprise an acceleration sensor to measure and acquire the vibration frequencies.

The calculation module 420 is configured to calculate a vibration quantity of the terminal driven by each candidate vibration motor respectively according to the vibration frequencies of the n candidate vibration motors.

The selection module 430 is configured to select a target vibration motor suitable for the terminal from the n candidate vibration motors according to the vibration quantities corresponding to the n candidate vibration motors, respectively.

Therefore, in some embodiments of the present disclosure, the vibration quantity of the terminal driven by each candidate vibration motor is calculated according to the vibration frequencies of the plurality of candidate vibration motors, so that the target vibration motor suitable for the terminal is selected according to the vibration quantities. Compared with the related art where the vibration quantity is tested after the vibration motor is mounted in the terminal, the operation in the technical solution provided by the embodiment of the present disclosure is more efficient and more concise as the vibration quantity of the terminal can be calculated without the vibration motor being mounted in the terminal. In addition, calculation and test are performed before the vibration motors are mounted in the terminal in the present disclosure, so that the reasonableness, correctness and timeliness of selection of the appropriate vibration motor can be ensured.

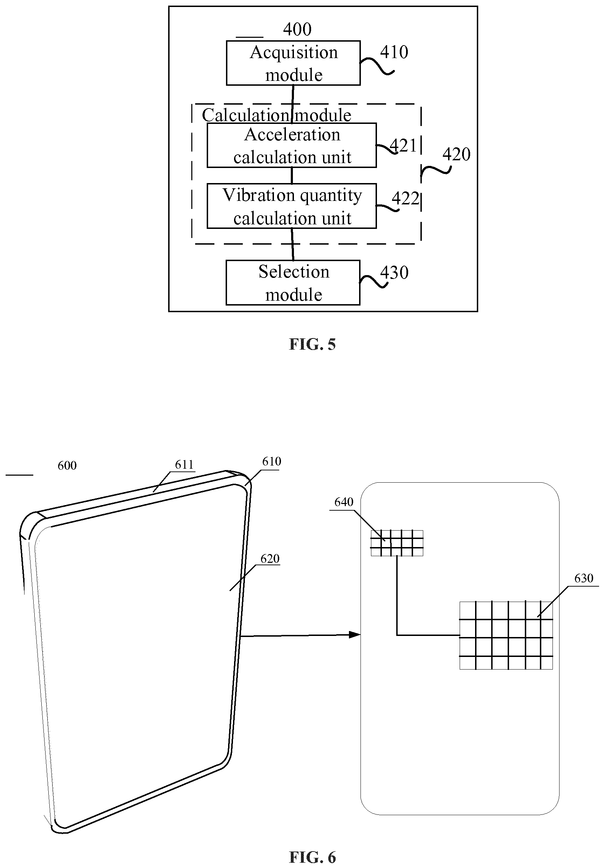

In some embodiments provided on the basis of the embodiment in FIG. 4, as shown in FIG. 5, the calculation module 420 includes an acceleration calculation unit 421 and a vibration quantity calculation unit 422.

The acceleration calculation unit 421 is configured to calculate, for an i-th candidate vibration motor in the n candidate vibration motors, a vibration acceleration of the terminal driven by the i-th candidate vibration motor according to the vibration frequency of the i-th candidate vibration motor.

The vibration quantity calculation unit 422 is configured to calculate a vibration quantity $G_i$ of the terminal driven by the i-th candidate vibration motor according to the following formula:

$$G_i = \frac{a_i}{g},$$

wherein $a_i$ represents the vibration acceleration of the terminal driven by the i-th candidate vibration motor, and g represents the gravitational acceleration.

In some embodiments, the acceleration calculation unit 421 is configured to:

calculate a driving force generated by the i-th candidate vibration motor according to the vibration frequency of the i-th candidate vibration motor; and
calculate the vibration acceleration $a_i$ of the terminal driven by the i-th candidate vibration motor according to the following formula:

$$a_i = T\frac{F_i}{M},$$

wherein $F_i$ represents the driving force generated by the i-th candidate vibration motor, T represents an amplification coefficient of the vibration quantity, and M represents the mass of the terminal.

In some embodiments, the acceleration calculation unit is further configured to:

calculate an angular velocity $w_i$ of the i-th candidate vibration motor according to the following formula:

$$w_i = 2\pi f_i,$$

wherein $f_i$ represents the vibration frequency of the i-th candidate vibration motor; and
calculate the driving force $F_i$ generated by the i-th candidate vibration motor according to the following formula:

$$F_i = m_i r_i w_i^2,$$

wherein $m_i$ represents a centroid mass of the i-th candidate vibration motor, and $r_i$ represents a centroid radius of the i-th candidate vibration motor.

In another optional embodiment provided on the basis of the embodiment in FIG. 4 or any of the foregoing optional embodiments, the selection module 430 is configured to:
select the candidate vibration motor with the largest vibration quantity as the target vibration motor suitable for the terminal from the n candidate vibration motors.

It should be noted that, the function realization of the device provided by the above embodiments is only illustrated by example of divided functional modules as the above-mentioned. While in practice, the above functions may be assigned to different modules to achieve according to practical needs. That is, the internal structure of the device may be divided into different functional modules, so as to achieve all or part of the functions described above.

With respect to the device in the above embodiments, the specific manners for individual modules in the device to perform operations have been described in detail in the embodiments of the related methods, and will not be elaborated herein.

Another exemplary embodiment of the present disclosure further provides a device for selecting a vibration motor, and the device is capable of implementing the method for selecting the vibration motor provided by the present disclosure. The device includes a processor and a memory configured to store processor executable instructions, wherein the processor is configured to:

acquire vibration frequencies of n candidate vibration motors for the terminal, n being an integer greater than 1;
calculate the vibration quantity of the terminal driven by each candidate vibration motor according to the vibration frequencies of the n candidate vibration motors; and
select a target vibration motor suitable for the terminal from the n candidate vibration motors according to the vibration quantities corresponding to the n candidate vibration motors, respectively.

In some embodiments, the processor is configured to:

calculate, for an i-th candidate vibration motor in the n candidate vibration motors, the vibration acceleration of the terminal driven by the i-th candidate vibration motor according to the vibration frequency of the i-th candidate vibration motor; and
calculate a vibration quantity $G_i$ of the terminal driven by the i-th candidate vibration motor according to the following formula:

$$G_i = \frac{a_i}{g},$$

wherein $a_i$ represents the vibration acceleration of the terminal driven by the i-th candidate vibration motor, and g represents the gravitational acceleration.

In some embodiments, the processor is configured to:

calculate a driving force generated by the i-th candidate vibration motor according to the vibration frequency of the i-th candidate vibration motor; and
calculate the vibration acceleration $a_i$ of the terminal driven by the i-th candidate vibration motor according to the following formula:

$$a_i = T \frac{F_i}{M},$$

wherein $F_i$ represents the driving force generated by the i-th candidate vibration motor, T represents an amplification coefficient of the vibration quantity, and M represents the mass of the terminal.

In some embodiments, the processor is configured to:

calculate an angular velocity $w_i$ of the i-th candidate vibration motor according to the following formula:

$$w_i = 2\pi f_i,$$

wherein $f_i$ represents the vibration frequency of the i-th candidate vibration motor; and

calculate the driving force $F_i$ generated by the i-th candidate vibration motor according to the following formula:

$$F_i = m_i r_i w_i^2 \ ,$$

wherein $mi$ represents a centroid mass of the i-th candidate vibration motor, and $r_i$ represents a centroid radius of the i-th candidate vibration motor.

In some embodiments, the processor is configured to:

select the candidate vibration motor with the largest vibration quantity as the target vibration motor suitable for the terminal from the n candidate vibration motors.

FIG. 6 shows a structural block diagram of a terminal according to an exemplary embodiment of the present disclosure. The terminal 600 may be an electronic equipment such as a mobile phone, a tablet computer, an e-book reader, a game machine, or a wearable equipment.

The terminal includes a device body 610, a display screen 620, a processor 630, and a target vibration motor 640.

The device body 610, also referred to as a device bodywork, is the main body frame of the terminal. The device body 610 is generally in the shape of a hexahedron, and a fillet may be formed at a part of edges or corners of the hexahedron. The front face of the device body 610 is generally a rounded rectangle or a rectangle.

In some embodiments, the device body 610 includes a middle frame 611 which is a frame around the device body. The display screen 620 is arranged on the front face of the device body 610, is attached to the middle frame 611, and is configured to display images and colors. In some embodiments, the display screen 620 is a touch display screen which has a function of receiving a touch operation (such as clicking, sliding, pressing, etc.) of the user besides the display function. In some embodiments, the display screen 620 may be a self-luminous display screen, such as an OLED (Organic Light-Emitting Diode) screen. In some other embodiments, the display screen 620 can be a liquid-crystal display (LCD), or other types of displays.

In some embodiments, the terminal can be a mobile phone, which can further include a microphone, a speaker, and other components for communications through the mobile phone.

In some embodiments, the above terminal further includes a processor 630 coupled with a target vibration motor 640. The processor 630 is a central control system of the whole mobile terminal, and is also the control center of a logical part. The processor 630 achieves the purpose of controlling the terminal by running software in the memory and calling a database in the memory.

The target vibration motor 640 is arranged in the terminal to drive the terminal to vibrate. The target vibration motor 640 is selected by using the method provided in the embodiment of FIG. 1.

It should be noted that FIG. 6 is a structural block diagram of an exemplary terminal. The positions of the processor 630 and the target vibration motor 640 in the terminal may be determined according to actual conditions, and are not limited in the embodiments of the present disclosure.

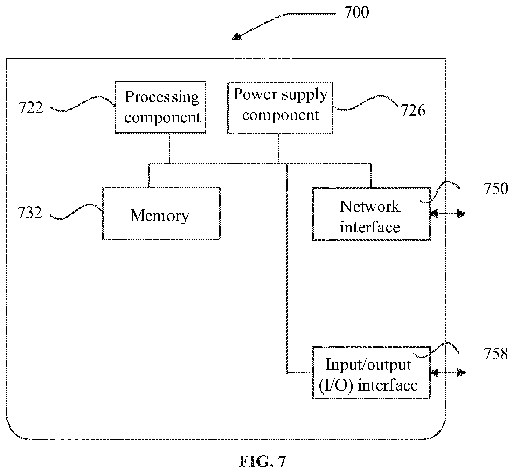

FIG. 7 is a block diagram of a computer equipment 700 according to an exemplary embodiment. For example, the computer equipment 700 may be provided as a server. Referring to FIG. 7, the computer equipment 700 includes a processing component 722. The processing component 722 further includes one or more processors, and a memory resource represented by a memory 732 for storing executable instructions, such as applications (Apps), for the processing component 722. The applications stored in the memory 732 may include one or more modules, each of which corresponds to a set of instructions. In addition, the processing component 722 is configured to execute instructions to perform the above method for selecting the vibration motor.

The computer equipment 700 can further include: a power supply component 726 configured to manage power supply of the computer equipment 700, a wired or wireless network interface 750 configured to connect the computer equipment 700 to a network, and an input/output (I/O) interface 758. The computer equipment 700 can operate an operating system based on the one stored in the memory 732, such as Windows ServerTM, Mac OS XTM, UnixTM, LinuxTM, FreeBSDTM, or the like.

In an exemplary embodiment, a non-transitory computer-readable storage medium is further provided, wherein a computer program is stored in the storage medium. The computer equipment 700 can implement the above method for selecting the vibration motor when the computer program is executed by the processor of the computer equipment 700. For example, the non-transitory computer-readable storage medium may be an ROM, a random-access memory (RAM), a CD-ROM, a magnetic tape, a floppy disc, optical data storage equipment, and the like.

In some embodiments, the processing component or processing circuit 722 can be implemented with one or more application specific integrated circuits (ASICs), digital signal processors (DSPs), digital signal processing devices (DSPDs), programmable logic devices (PLDs), field programmable Gate array (FPGA), controller, microcontroller, microprocessor or other electronic components to perform the above method.

Some embodiments of the present disclosure can have one or more of the following advantages.

The vibration quantity of the terminal driven by each candidate vibration motor is calculated according to the vibration frequencies of the plurality of candidate vibration motors, so that the target vibration motor suitable for the terminal is selected according to the vibration quantity. Compared with the related art where the vibration quantity is tested after the vibration motor is mounted in the terminal, the operation in the technical solution provided by the embodiment of the present disclosure is more efficient and more concise as the vibration quantity of the terminal can be calculated without the vibration motor being mounted in the terminal. In addition, calculation and test are performed before the vibration motors are mounted in the terminal in the present disclosure, so that the reasonableness, correctness, and timeliness of selection of the vibration motor are ensured.

Therefore, during the design process of the terminal, so long as a mass of the terminal and structure, e.g., where the target motor is to be installed, are determined, a test system implementing the method above can help select a suitable vibration motor for the terminal. The suitable target vibration motor, once selected, can be installed in or integrated with the terminal with the predetermined mass.

The target vibration motor installed in the terminal at the predetermined location, such as the location indicated by the vibration motor 640 in the mobile phone 600 illustrated in FIG. 6, would produce the desired vibrations of the design specifications, as the vibration amplitude and frequencies may depend on the mass of the mobile phone with the vibration motor installed, the location of the vibration motor in the mobile phone, and the materials of the mobile phone, etc. Such parameters can collectively determine a characteristic vibration frequency of the mobile phone 600.

It should be understood that the term "plurality" herein refers to two or more. "And/or" herein describes the association relationship between the associated objects, indicating three kinds of relationships. For example, A and/or B, can be expressed as: A exists alone, A and B exist concurrently, B exists alone. The character "/" generally indicates that the relationship between the context objects is an "OR" relationship.

In the present disclosure, it is to be understood that the terms "lower," "upper," "front," "back," "left," "right," "top," "bottom," "inner," "outer," "horizontal," "vertical," and other orientation or positional relationships are based on example orientations illustrated in the drawings, and are merely for the convenience of the description of some embodiments, rather than indicating or implying the device or component being constructed and operated in a particular orientation. Therefore, these terms are not to be construed as limiting the scope of the present disclosure.

Moreover, the terms "first" and "second" are used for descriptive purposes only and are not to be construed as indicating or implying a relative importance or implicitly indicating the number of technical features indicated. Thus, elements referred to as "first" and "second" may include one or more of the features either explicitly or implicitly. In the description of the present disclosure, "a plurality" indicates two or more unless specifically defined otherwise.

In the present disclosure, a first element being "on," a second element may indicate direct contact between the first and second elements, without contact, or indirect through an intermediate medium, unless otherwise explicitly stated and defined.

In the description of the present disclosure, the terms "some embodiments," "example," or "some examples," and the like may indicate a specific feature described in connection with the embodiment or example, a structure, a material or feature included in at least one embodiment or example. In the present disclosure, the schematic representation of the above terms is not necessarily directed to the same embodiment or example.

Moreover, the particular features, structures, materials, or characteristics described may be combined in a suitable manner in any one or more embodiments or examples. In addition, various embodiments or examples described in the specification, as well as features of various embodiments or examples, may be combined and reorganized.

Implementations of the subject matter and the operations described in this disclosure can be implemented with hardware such as digital electronic circuitry or processing circuits, or in computer software, firmware, or hardware, including the structures disclosed herein and their structural equivalents, or in combinations of one or more of them. Implementations of the subject matter described in this disclosure can be implemented as one or more computer programs, i.e., one or more modules of computer program instructions, encoded or stored on one or more non-transitory computer-readable storage medium for execution by, or to control the operation of, data processing apparatus.

Alternatively, or in addition, the program instructions can be encoded on an artificially-generated propagated signal, e.g., a machine-generated electrical, optical, or electromagnetic signal, that is generated to encode information for transmission to suitable receiver apparatus for execution by a data processing apparatus. A computer storage medium can be, or be included in, a computer-readable storage device, a computer-readable storage substrate, a random or serial access memory array or device, or a combination of one or more of them.

Moreover, while a computer storage medium is not a propagated signal, a computer storage medium can be a source or destination of computer program instructions encoded in an artificially-generated propagated signal. The computer storage medium can also be, or be included in, one or more separate components or media (e.g., multiple CDs, disks, drives, or other storage devices). Accordingly, the computer storage medium may be tangible.

The operations described in this disclosure can be implemented as operations performed by a data processing apparatus on data stored on one or more computer-readable storage devices or received from other sources.

While this specification contains many specific implementation details, these should not be construed as limitations on the scope of any claims, but rather as descriptions of features specific to particular implementations. Certain features that are described in this specification in the context of separate implementations can also be implemented in combination in a single implementation. Conversely, various features that are described in the context of a single implementation can also be implemented in multiple implementations separately or in any suitable subcombinations.

Moreover, although features can be described above as acting in certain combinations and even initially claimed as such, one or more features from a claimed combination can in some cases be excised from the combination, and the claimed combination can be directed to a subcombination or variations of a subcombination.

Similarly, while operations are depicted in the drawings in a particular order, this should not be understood as requiring that such operations be performed in the particular order shown or in sequential order, or that all illustrated operations be performed, to achieve desirable results. In certain circumstances, multitasking and parallel processing can be advantageous. Moreover, the separation of various system components in the implementations described above should not be understood as requiring such separation in all implementations, and it should be understood that the described program components and systems can generally be integrated together in a single software product or packaged into multiple software products.

As such, particular implementations of the subject matter have been described. Other implementations are within the scope of the following claims. In some cases, the actions recited in the claims can be performed in a different order and still achieve desirable results. In addition, the processes depicted in the accompanying figures do not necessarily require the particular order shown, or sequential order, to achieve desirable results. In certain implementations, multitasking or parallel processing can be utilized.

Some other embodiments of the present disclosure can be available to those skilled in the art upon consideration of the specification and practice of the various embodiments disclosed herein. The present application is intended to cover any variations, uses, or adaptations of the present disclosure following general principles of the present disclosure and include the common general knowledge or conventional technical means in the art without departing from the present disclosure. The specification and examples can be shown as illustrative only, and the true scope of the disclosure are indicated by the following claims.

**Claims**

1. A method for selecting a target vibration motor among several candidate vibration motors, wherein the target vibration motor is to be arranged in a terminal to drive the terminal to vibrate, the method comprising:

   acquiring vibration frequencies of n candidate vibration motors for the terminal, n being an integer greater than 1;
   calculating a vibration quantity of the terminal driven by each candidate vibration motor respectively according to the vibration frequencies of the n candidate vibration motors; and
   selecting the target vibration motor suitable for the terminal from the n candidate vibration motors according to the vibration quantities corresponding to the n candidate vibration motors, respectively.

2. The method of claim 1, wherein the calculating the vibration quantity of the terminal driven by each candidate vibration motor respectively according to the vibration frequencies of the n candidate vibration motors comprises:

   for an i-th candidate vibration motor in the n candidate vibration motors, calculating a vibration acceleration of the terminal driven by the i-th candidate vibration motor according to the vibration frequency of the i-th candidate vibration motor; and
   calculating a vibration quantity $G_i$ of the terminal driven by the i-th candidate vibration motor according to the following formula:

   $$G_i = \frac{a_i}{g},$$

   wherein $a_i$ represents the vibration acceleration of the terminal driven by the i-th candidate vibration motor, and g represents gravitational acceleration.

3. The method of claim 2, wherein the calculating the vibration acceleration of the terminal driven by the i-th candidate vibration motor according to the vibration frequency of the i-th candidate vibration motor comprises:

   calculating a driving force generated by the i-th candidate vibration motor according to the vibration frequency of the i-th candidate vibration motor; and
   calculating the vibration acceleration $a_i$ of the terminal driven by the i-th candidate vibration motor according to the following formula:

$$a_i = T \frac{F_i}{M},$$

wherein $F_i$ represents the driving force generated by the i-th candidate vibration motor, T represents an amplification coefficient of the vibration quantity, and M represents a mass of the terminal.

4. The method of claim 3, wherein the calculating the driving force generated by the i-th candidate vibration motor according to the vibration frequency of the i-th candidate vibration motor comprises:

  calculating an angular velocity $w_i$ of the i-th candidate vibration motor according to the following formula:

$$w_i = 2\pi f_i,$$

  wherein $f_i$ represents the vibration frequency of the i-th candidate vibration motor; and calculating the driving force $F_i$ generated by the i-th candidate vibration motor according to the following formula:

$$F_i = m_i r_i w_i^2,$$

  wherein $m_i$ represents a centroid mass of the i-th candidate vibration motor, and $r_i$ represents a centroid radius of the i-th candidate vibration motor.

5. The method of any of claims 1-4, wherein the selecting the target vibration motor suitable for the terminal from the n candidate vibration motors according to the vibration quantities corresponding to the n candidate vibration motors comprises:
selecting the candidate vibration motor with the largest vibration quantity as the target vibration motor suitable for the terminal from the n candidate vibration motors.

6. A device for selecting a target vibration motor among several candidate vibration motors, wherein the target vibration motor is to be arranged in a terminal to drive the terminal to vibrate, the device comprises:

  a processor; and
a memory configured to store instructions executable by the processor,
wherein the processor is configured to:

acquire vibration frequencies of n candidate vibration motors for the terminal, n being an integer greater than 1;
calculate a vibration quantity of the terminal driven by each candidate vibration motor respectively according to the vibration frequencies of the n candidate vibration motors; and
select the target vibration motor suitable for the terminal from the n candidate vibration motors according to the vibration quantities corresponding to the n candidate vibration motors, respectively.

7. The device of claim 6, wherein the calculating the vibration quantity of the terminal driven by each candidate vibration motor respectively according to the vibration frequencies of the n candidate vibration motors comprises:

  for an i-th candidate vibration motor in the n candidate vibration motors, calculating a vibration acceleration of the terminal driven by the i-th candidate vibration motor according to the vibration frequency of the i-th candidate vibration motor; and
calculating a vibration quantity $G_i$ of the terminal driven by the i-th candidate vibration motor according to the following formula:

$$G_i = \frac{a_i}{g},$$

  wherein $a_i$ represents the vibration acceleration of the terminal driven by the i-th candidate vibration motor, and g represents the gravitational acceleration.

8. The device of claim 7, wherein the calculating the vibration acceleration of the terminal driven by the i-th candidate vibration motor according to the vibration frequency of the i-th candidate vibration motor comprises:

  calculating a driving force generated by the i-th candidate vibration motor according to the vibration frequency of the i-th candidate vibration motor; and
calculating the vibration acceleration $a_i$ of the terminal driven by the i-th candidate vibration motor according to the following formula:

$$a_i = T \frac{F_i}{M},$$

  wherein $F_i$ represents the driving force generated by the i-th candidate vibration motor, T represents an amplification coefficient of the vibration quantity, and M represents a mass of the terminal.

9. The device of claim 8, wherein the calculating the driving force generated by the i-th candidate vibration motor according to the vibration frequency of the i-th candidate vibration motor comprises:

calculating an angular velocity $w_i$ of the i-th candidate vibration motor according to the following formula:

$$w_i = 2\pi f_i \ ,$$

wherein $f_i$ represents the vibration frequency of the i-th candidate vibration motor; and calculating the driving force $F_i$ generated by the i-th candidate vibration motor according to the following formula:

$$F_i = m_i r_i w_i^2 \ ,$$

wherein $m_i$ represents a centroid mass of the i-th candidate vibration motor, and $r_i$ represents a centroid radius of the i-th candidate vibration motor.

10. The device of any of claims 6-9, wherein the selecting the target vibration motor suitable for the terminal from the n candidate vibration motors according to the vibration quantities corresponding to the n candidate vibration motors comprises:
selecting the candidate vibration motor with the largest vibration quantity as the target vibration motor suitable for the terminal from the n candidate vibration motors.

11. A non-transitory computer-readable storage medium, wherein a computer program is stored in the storage medium for execution by a processor to implement operations including:

acquiring vibration frequencies of candidate vibration motors for the terminal, n being an integer greater than 1;
calculating a vibration quantity of the terminal driven by each candidate vibration motor respectively according to the vibration frequencies of the n candidate vibration motors; and
selecting a target vibration motor suitable for the terminal from the n candidate vibration motors according to the vibration quantities corresponding to the n candidate vibration motors, respectively.

12. The non-transitory computer-readable storage medium of claim 11, wherein the calculating the vibration quantity of the terminal driven by each candidate vibration motor respectively according to the vibration frequencies of the n candidate vibration motors comprises:

for an i-th candidate vibration motor in the n candidate vibration motors, calculating a vibration acceleration of the terminal driven by the i-th candidate vibration motor according to the vibration frequency of the i-th candidate vibration motor; and
calculating a vibration quantity $G_i$ of the terminal driven by the i-th candidate vibration motor according to the following formula:

$$G_i = \frac{a_i}{g},$$

wherein $a_i$ represents the vibration acceleration of the terminal driven by the i-th candidate vibration motor, and g represents the gravitational acceleration.

13. The non-transitory computer-readable storage medium of claim 12, wherein the calculating the vibration acceleration of the terminal driven by the i-th candidate vibration motor according to the vibration frequency of the i-th candidate vibration motor comprises:

calculating a driving force generated by the i-th candidate vibration motor according to the vibration frequency of the i-th candidate vibration motor; and
calculating the vibration acceleration $a_i$ of the terminal driven by the i-th candidate vibration motor according to the following formula:

$$a_i = T\frac{F_i}{M},$$

wherein $F_i$ represents the driving force generated by the i-th candidate vibration motor, T represents an amplification coefficient of the vibration quantity, and M represents a mass of the terminal.

14. The non-transitory computer-readable storage medium of claim 13, wherein the calculating the driving force generated by the i-th candidate vibration motor according to the vibration frequency of the i-th candidate vibration motor comprises:

calculating an angular velocity $w_i$ of the i-th candidate vibration motor according to the following formula:

$$w_i = 2\pi f_i,$$

wherein $f_i$ represents the vibration frequency of the i-th candidate vibration motor; and calculating the driving force $F_i$ generated by the i-th candidate vibration motor according to the following formula:

$$F_i = m_i r_i w_i^2,$$

wherein $m_i$ represents a centroid mass of the i-th candidate vibration motor, and $r_i$ represents a centroid radius of the i-th candidate vibration motor.

15. The non-transitory computer-readable storage medium of any one of claims 11-14, wherein the selecting the target vibration motor suitable for the terminal from the n candidate vibration motors according to the vibration quantities corresponding to the n candidate vibration motors comprises:
selecting the candidate vibration motor with the largest vibration quantity as the target vibration motor suitable for the terminal from the n candidate vibration motor.

Vibration frequencies of n candidate vibration motors for the terminal are acquired, n being an integer greater than 1.    101

A vibration quantity of the terminal driven by each candidate vibration motor is calculated according to the vibration frequencies of the n candidate vibration motors.    102

A target vibration motor suitable for the terminal is selected from the n candidate vibration motors according to the vibration quantities corresponding to the n candidate vibration motors, respectively.    103

FIG. 1

FIG. 2

**FIG. 3**

**FIG. 4**

**FIG. 5**

**FIG. 6**

700

722

Processing component

Power supply component

726

732

Memory

Network interface

750

Input/output (I/O) interface

758

**FIG. 7**

Europäisches
Patentamt

European
Patent Office

Office européen
des brevets

## EUROPEAN SEARCH REPORT

**Application Number**

EP 19 20 6168

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 102 819 450 B (HUIZHOU TCL MOBILE COMM CO LTD) 17 August 2016 (2016-08-17) * abstract * ----- | 1-15 | INV. H02N2/10 G06F30/20 G06F3/01 |

TECHNICAL FIELDS SEARCHED (IPC)

H02N
G06F

The present search report has been drawn up for all claims

| Place of search | Date of completion of the search | Examiner |
|---|---|---|
| Munich | 17 April 2020 | Anticoli, Claud |

EPO FORM 1503 03.82 (P04C01)

## ANNEX TO THE EUROPEAN SEARCH REPORT
## ON EUROPEAN PATENT APPLICATION NO.

EP 19 20 6168

This annex lists the patent family members relating to the patent documents cited in the above-mentioned European search report.
The members are as contained in the European Patent Office EDP file on
The European Patent Office is in no way liable for these particulars which are merely given for the purpose of information.

17-04-2020

| Patent document cited in search report | | Publication date | Patent family member(s) | Publication date |
|---|---|---|---|---|
| CN 102819450 | B | 17-08-2016 | NONE | |

For more details about this annex : see Official Journal of the European Patent Office, No. 12/82

EPO FORM P0459